# EUROPÄISCHE PATENTSCHRIFT

(11) **EP 2 892 844 B1**
(45) Veröffentlichungstag und Bekanntmachung des Hinweises auf die Patenterteilung: **22.06.2016**
(21) Anmeldenummer: 13771455.6
(22) Anmeldetag: 27.09.2013
(51) Int. Cl.: G02B 26/08, H01L 21/3065

(54) **VERFAHREN ZUR HERSTELLUNG EINES DECKELS FÜR OPTISCHE MEMS VERPACKUNGEN**
METHOD FOR PRODUCING A COVER FOR OPTICAL MEMS PACKAGING
PROCÉDÉ DE FABRICATION D'UN COUVERCLE POUR DES ENCAPSULATIONS DE MEMS OPTIQUES

(30) Priorität: 28.09.2012 DE 102012217793
(43) Veröffentlichungstag der Anmeldung: 15.07.2015
(73) Patentinhaber: Fraunhofer-Gesellschaft zur Förderung der angewandten Forschung e.V., 80686 München (DE)
(72) Erfinder: LANGA, Sergiu, 01328 Dresden (DE); DRABE, Christian, 01099 Dresden (DE); SANDNER, Thilo, 01156 Dresden (DE)
(74) Vertreter: Hersina, Günter
(86) Internationale Anmeldenummer: PCT/EP2013/070246
(87) Internationale Veröffentlichungsnummer: WO 2014/049141

(56) Entgegenhaltungen:
- WO-A1-03/058330
- US-A- 4 307 507
- US-A1- 2010 330 332

## Beschreibung

Ausführungsbeispiele der vorliegenden Erfindung beziehen sich auf ein Herstellungsverfahren. Weitere Ausführungsbeispiele der vorliegenden Erfindung beziehen sich auf ein Verfahren zur Herstellung von gekippten Glasfenstern zur Verkapselung von Mikrosystemen auf Waferebene. Weitere Ausführungsbeispiele der vorliegenden Erfindung beziehen sich auf ein Herstellungsverfahren für ein Gehäuse zur Verkapselung eines Mikroscannerspiegels.

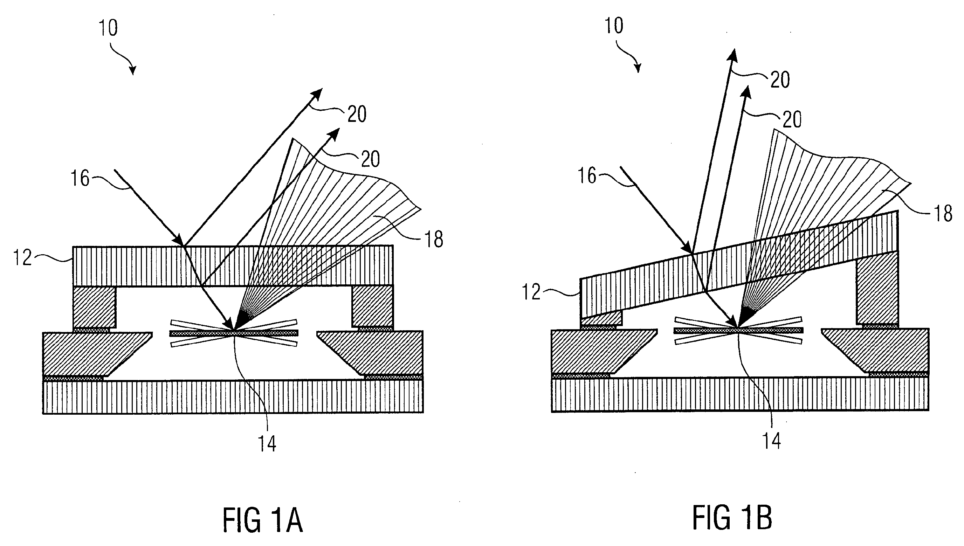

Es gibt viele Gründe, wieso Mikrosystemchips gehaust werden müssen. Der offensichtlichste ist es, die Mikrosystemchips vor der Umgebung zu schützen [K. Najafi, "Micropackaging Technologies for Integrated Microsystems: Applications to MEMS and MOEMS", Micromachining and Microfabrication Process Technology VIII, Proceedings of SPIE 4979, 0 (2003)]. "Schutz" bedeutet dabei jedoch nicht "totale Isolation" des Mikrosystemchips von der Umgebung. Normalerweise kommunizieren Mikrosystemchips mit der Umgebung mittels elektrischer, optischer oder akustischer Signale. Wenn ein Mikrosystemchip eine optische Kommunikation mit der Umgebung erfordert, dann ist es die intuitivste Lösung ein Fenster, das für den Wellenlängenbereich, der für die optische Kommunikation erforderlich ist, transparent ist, in das Gehäuse des Mikrosystemchips zu integrieren, wie dies in Fig. 1a gezeigt ist.

Fig. 1a zeigt eine schematische Ansicht eines Gehäuses 10 mit einem Fenster 12 zur Verkapselung eines MSD-Chips mit einem Mikroscannerspiegel 14 (MSD = micro scanner devices, dt. Mikroscannervorrichtungen). Ein einfallender Lichtstrahl 16 trifft auf die Oberfläche des Mikroscannerspiegels 14 und wird als reflektierter Lichtstrahl 18 in Abhängigkeit von der Auslenkung des Mikroscannerspiegels 14 in eine vorgegebene Region reflektiert. An der Oberseite und Unterseite des Fensters 12 entstehen jedoch parasitäre Reflexionen 20 des einfallenden Lichtstrahls 16, die in die gleiche Region, wie der von dem Mikroscannerspiegel 14 reflektierte Lichtstrahl 18, reflektiert werden, wodurch die Qualität des von dem Mikroscannerspiegel 14 generierten Bildes beeinträchtig wird.

Solche MSD-Chips sind beispielsweise aus [H. Schenk, "The high versatility of silicon based micro-optical modulators", MOEMS and Miniaturized Systems VII, ed. D.L. Dickensheets, H. Schenk, Proc. of SPIE 7208, 720802 (2009)] bekannt.

Ein weiteres Problem kann der Fabry-Perot- Effekt bei parallel zum Deckel schwingenden MOEMS-Spiegeln sein, wie sie z.B. in FTIR-Systemen zur Anwendung kommen. Auch hier kann dieser störende Effekt durch eine Verkippung des Fensters reduziert oder eliminiert werden.

Es ist keine triviale Aufgabe ein Fenster 12 in das Gehäuse 10 eines Mikrosystemchips zu integrieren. Noch anspruchsvoller ist es, das Gehäuse hermetisch zu versiegeln [G. A. Riley, "Wafer-level Hermetic Cavity Packaging", Advanced Packaging Magazine 13(5), 21 (2004)] und das Fenster 12 gekippt zu dem Mikroscannerspiegel 14 anzuordnen, wie dies in Fig. 1b gezeigt ist.

Darüber hinaus erfordern MSD-Chips eine Vakuumverkapselung, um einerseits den Energieverbrauch des oszillierenden Mikroscannerspiegels zu minimieren und andererseits die Auflösung des Projektionssystems zu erhöhen [Hofmann et. al., "Wafer-level vacuum packaged micro-scanning mirrors for compact laser projection displays", MOEMS and Miniaturized Systems VII, ed. D.L. Dickensheets, H. Schenk, Proc. of SPIE 6887, 688706 (2008)]. Ferner ist ein gekipptes Fenster 12 erforderlich, um Bildverzerrungen durch parasitäre Reflexionen 20 an den Oberflächen des Fensters 12 zu vermeiden. Die parasitären Reflexionen werden durch den Unterschied im Brechungsindex zwischen dem Material des Fensters 12 (z.B. Glas) und der Luft hervorgerufen. Bei einem zu der Vorrichtung (z.B. Mikroscannerspiegel) parallelen Fenster 12 werden die parasitären Reflexionen, wie in Fig. 1a gezeigt ist, in die gleiche Region reflektiert, wie das projizierte Licht bzw. Bild 18. Daher kommt es zu einem parasitären Punkt bzw. Fleck, der das projizierte Bild 18 permanent stört bzw. beeinträchtigt, was insbesondere für hochqualitative Projektionssysteme inakzeptabel ist.

Es gibt verschiedene Ansätze, um das projizierte Bild 18 von den parasitären Reflexionen 20 zu befreien. Beispielsweise kann ein Bragg-Reflektor verwendet werden, der auf die Oberfläche (z.B. Oberseite) des Fensters 12 in Form eines geeigneten Schichtstapels (engl.: layer-stack) abgeschieden wird. Allerdings kann dadurch nur ein schmaler Wellenlängenbereich unterdrückt werden, womit diese Lösung nicht für die Projektion von Farbbildern geeignet ist.

Wie bereits oben erwähnt wurde, besteht eine andere Möglichkeit darin, das Fenster 12 relativ zu der Vorrichtung in einem geeigneten Winkel zu kippen. Wie in Fig. 1b gezeigt ist, liegen die parasitären Reflexionen 20 somit nicht mehr in dem Projektionsbereich, womit das projizierte Bild nicht mehr gestört wird. Der gleiche Effekt kann erzielt werden, wenn anstelle des Fensters 12, die Vorrichtung relativ zu dem Fenster 12 gekippt wird. In beiden Fällen entsteht in der Praxis das Problem der Implementierung, insbesondere unter Berücksichtigung, dass das Gehäuse vakuumdicht und kostengünstig sein sollte.

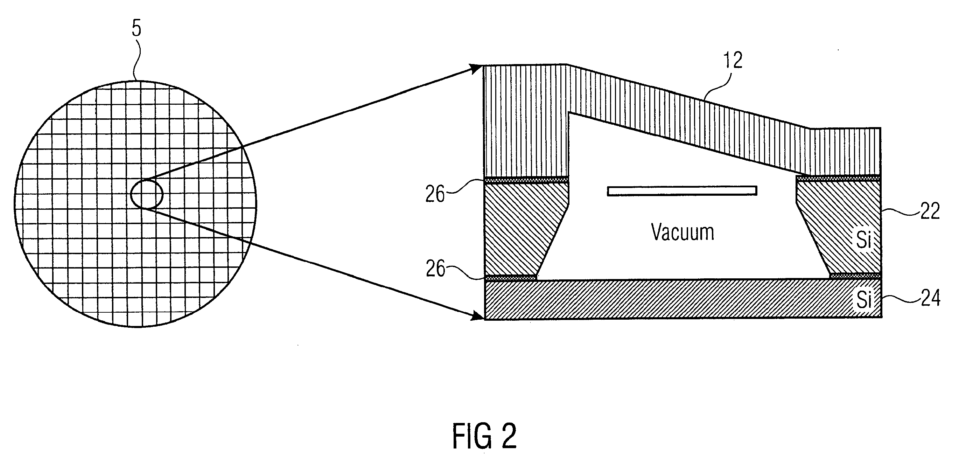

Eine effiziente Möglichkeit, um ein kostengünstiges Vakuumgehäuse zu realisieren ist WLP (WLP = wafer level packaging, dt. hausen auf Waferebene), wie dies in Fig. 2 gezeigt ist. Dabei werden die Chips auf z.B. einem sechs oder acht Zoll Wafer simultan durch Bondverfahren zwischen einem Vorrichtungswafer 22 (engl.: device wafer), der die Mikrosystemchips aufweist, und einem oder mehreren Deckelwafer(n) 12 und 24 (engl.: cap wafer) gehaust [M A. Schmidt, "Wafer-to-Wafer Bonding for Microstructure Formation", Proceedings of the IEEE 86(8), 1575 (1998)] [V. Dragoi, "Wafer Bonding: Key Enabling Technology for Photonic Integration", http://www.ieee.org/organizations/pubs/newsletters/leos/dec09/RH-Wafer_Bonding.html (2009)]. Natürlich sollte einer der Deckelwafer 12 oder 24, z.B. der obere Deckelwafer 12, zum Hausen von MSD-Chips ein Array von gekippten Fenstern 12 aufweisen.

Für die praktische Implementierung der in Fig. 2 gezeigten Struktur sind somit die im Folgenden genannten Merkmale erforderlich. Ein Vorrichtungswafer, der die MSD-Chips 22 aufweist, ein oberer Deckelwafer, der die gekippten Fenster 12 aufweist, ein unterer Deckelwafer, z.B. ein roher Siliziumwafer 24, und ein geeignetes Bondverfahren, um die Wafer zu Bonden 26. Fig. 2 zeigt dabei ein Beispiel eines vakuumgehausten Chips mit einem Fenster (aus z.B. Glas) zur Interaktion mit der Umgebung.

Zum Bonden von Glas und Silizium, oder von Silizium und Silizium gibt es mehrere, gut etablierte Verfahren, wie z.B. anodisches Bonden, eutektisches Bonden und direktes Bonden. Das Hauptproblem bei der Herstellung der in Fig. 2 gezeigten Struktur ist somit nicht das Bonden der Wafer, sondern die Herstellung eines optisch qualitativ hochwertigen und mechanisch stabilen oberen Deckelwafers, der ein Array von gekippten Fenstern 12 aufweist.

Die Herausforderungen bei der Herstellung von oberen Deckelwafern mit gekippten Fenstern können somit wie folgt zusammengefasst werden. Erstens, müssen die gekippten Fenster 12 auf Waferebene (z.B. auf einem sechs oder acht Zoll Wafer) hergestellt werden, um den WLP-Ansatz nutzen zu können. Zweitens, kann Glas nicht einfach auf Waferebene durch Standardtechniken, wie z.B. Nassätzen, Trockenätzen, Laserätzen oder Laserstrukturieren, strukturiert werden. Drittens, müssen die Glaswafer nach der Strukturierung eine gute optische Qualität aufweisen, z.B. sollte die Rauheit der strukturierten Fenster, d.h. der Abstand zwischen dem höchsten und dem niedrigsten Punkt (engl.: peak to valley), kleiner sein als λ/10, um der Vorrichtung eine störungsfreie bzw. verzerrungsfreie Kommunikation mit der Umwelt zu ermöglichen. Viertens, da Glas sehr brüchig bzw. zerbrechlich ist und beim Bonden Druck zwischen den Bondpartner aufgebracht wird, sollte der endgültig strukturierte Wafer mit den gekippten Fenstern während des Bondprozesses nicht Brechen). Fünftens, sollte das verwendete Glas einen linearen thermischen Ausdehnungskoeffizienten aufweisen, der vergleichbar zu Silizium ist, um ein Brechen des Glases während des Bondprozesses zu vermeiden. Geeignete Gläser sind z.B. Pyrex® oder Borofloat®.

Typische Mikroherstellungsverfahren für Silizium auf Waferebene sind die Fotolithografie und das Ätzen. Als Ätztechnik werden normalerweise Nassätzen und Trockenätzen verwendet. Im Vergleich zu Silizium weist Glas keine kristallographischen Eigenschaften auf, so dass eine Strukturierung mittels Nassätzen, z.B. mittels gepuffertem Flusssäure-Ätzen (engl.: buffered HF etching; HF = Flusssäure), zu Mikrostrukturen mit gekrümmten Seitenwänden und niedrigen Aspektverhältnissen führt. Trockenätzen, z.B. reaktives Ionentiefenätzen, kann genutzt werden, um Mikrostrukturen mit geraden Seitenwänden zu erhalten, wobei jedoch die Tiefe der Mikrostrukturen von der langsamen Ätzrate begrenzt bzw. beschränkt wird.

Eine weitere Strukturierungstechnologie, die für die Strukturierung von Glas genutzt wird, ist die Laserstrukturierung. Aufgrund von schlechten thermischen Eigenschaften der meisten Gläser, kann diese Strukturierungsmethode zu Rissen in den Gläsern oder anderen Problemen, wie z.B. schlechte Oberflächenqualitäten der Gläser, führen. Darüber hinaus kann die Laserstrukturierung nicht zur großflächigen Strukturierung von z.B. sechs oder acht Zoll Wafern genutzt werden.

Bedingt durch die Beschränkungen der oben genannten Strukturierungstechniken erscheint derzeit die effektivste Technik zur Strukturierung von Glas das klassische Glasformen bzw. Glasblasen zu sein.

Es gibt mehrere Schriften, wie z.B. die WO 2004/1068665, US 6146917 und US 2005/0184304, die Herstellungsverfahren von optischen Fenstern für das Hausen von Mikrosystemchips auf Waferebene beschreiben. Allerdings verlaufen in den genannten Fällen die Fenster parallel zu den Vorrichtungswafern. Daher sind diese Herstellungsverfahren nicht für den oben beschriebenen MSD-Chip anwendbar.

Verfahren zur Herstellung von Arrays von gekippten bzw. geformten Fenstern werden in den WO 2009/112138 A2, US 2008/0280124 A1, WO 2007/069165, US 2006/0176539 A1 und US 2007/0024549 A1 beschrieben.

Beispielsweise wird in der WO 2009/112138 A2 ein Glasstrukturierungsprozess für das Hausen auf Waferebene beschrieben, wobei ein Glaswafer mit sogenannten "Dummy-Stützelementen" mit einem Siliziumwafer, der Kavitäten aufweist, gebondet wird. Während eines Annealing-Schritts (dt. ausheilen, glühen) bei einer Temperatur von über 820 °C erweicht das Glas, wobei die Dummy-Stützelemente in kontrollierter Weise in die Kavitäten gedrückt werden und dabei das Glas in gewünschter Weise formen.

In der US 2008/0280124 A1 wird ein Glasblasprozess auf Waferebene beschrieben [E. J Eklund and A.M. Shkel, "Glass Blowing on a Wafer Level", J. of Microelectromechanical Systems 16(2), 232 (2007)]. Der Prozess basiert auf dem Waferbonden eines Glaswafers und eines strukturierten Siliziumwafers unter atmosphärischem Druck. Der strukturierte Siliziumwafer enthält dabei ein Array von zylindrischen Kavitäten, die ein erhöhtes Volumen im Bulk des Substrats aufweisen, so dass ein signifikanter Gasanteil während des Bondprozesses in den Kavitäten gespeichert werden kann. Anschließend wird die gebondete Struktur einem Annealing-Schritt bei einer Temperatur von über 820°C ausgesetzt. Während des Annealing-Schritts expandiert das in den Siliziumkavitäten gespeicherte Gas, wobei die Annealing-Temperatur über dem Erweichungspunkt des verwendeten Glases liegt, so dass sich ein Array von sphärischen Glaskavitäten formt. Dieses Array von sphärischen Glaskavitäten auf Waferebene kann zum Hausen auf Waferebene von MSD-Chips verwendet werden, um die parasitären Reflexionen aus dem Projektionsfeld zu eliminieren. Allerdings können die sphärischen Kavitäten durch die mechanischen Kräfte, die während des Bondprozesses bzw. WLP-Prozesses aufgebracht werden, zerstört werden, da in diesem Fall keine ebene Fläche zur Krafteinleitung beim Bonden mehr besteht.

Der vorliegenden Erfindung liegt somit die Aufgabe zugrunde, ein Konzept zu schaffen, das die oben genannten Nachteile vermindert bzw. reduziert.

Diese Aufgabe wird durch ein Herstellungsverfahren gemäß Anspruch 1 gelöst.

Bei Ausführungsbeispielen wird ein Halbleitersubstrat bereitgestellt, dessen Gitterstruktur derart angeordnet ist, dass eine Gitterebene der Gitterstruktur, z.B. die (100) Gitterebene, nicht symmetrisch und mit einem Winkel α versetzt zu zumindest einem ersten Hauptoberflächenbereich oder einem zweiten Hauptoberflächenbereich des Halbleitersubstrats angeordnet ist und z.B. dadurch auch die für einen anisotropen "Ätzstop" relevante 111-Ebene asymmetrisch verkippt ist. Durch das Halbleitersubstrat mit der versetzt bzw. gekippt angeordneten Gitterebene kann durch anisotropes Ätzen eine Ätzstruktur bereitgestellt werden, die in einer Ebene, die senkrecht zu dem ersten Hauptoberflächenbereich des Halbleitersubstrats verläuft, zwei unterschiedliche Ätzwinkel bezüglich des ersten Hauptoberflächenbereichs aufweist. Dadurch, dass eine Abdeckungsschicht auf den ersten Hauptoberflächenbereich des Halbleitersubstrats derart angeordnet wird, dass die Abdeckungsschicht zumindest bereichsweise an der Ätzstruktur anliegt, weist auch die Abdeckungsschicht im Bereich der Ätzstruktur die zwei unterschiedlichen Winkel bezüglich des ersten Hauptoberflächenbereichs auf. Nach dem abschnittsweisen Entfernen des Materials des Halbleitersubstrats ausgehend von dem zweiten Hauptoberflächenbereich im Bereich der verformten Abdeckungsschicht, entsteht ein Fensterbereich in dem die Abdeckungsschicht nicht parallel, sondern versetzt bzw. gekippt zu dem ersten Hauptoberflächenbereich angeordnet ist.

Die vorliegende Erfindung wird bezugnehmend auf die beiliegenden Zeichnungen näher erläutert. Es zeigen:
- Fig. 1a: eine schematische Ansicht eines Gehäuses mit einem parallelen Fenster zur Verkapselung eines Mikrosystemchips;
- Fig. 1b: eine schematische Ansicht eines Gehäuses mit einem gekippten Fenster zur Verkapselung eines Mikrosystemchips;
- Fig. 2: eine schematische Ansicht eines Gehäuses mit einem gekippten Fenster zur Vakuumverkapselung eines Mikrosystemchips auf Waferebene;
- Fig. 3: ein Flussdiagramm eines Herstellungsverfahrens gemäß einem Ausführungsbeispiel der vorliegenden Erfindung;
- Fig. 4a: einen Querschnitt des Halbleitersubstrats nach dem Schritt des Bereitstellens des Halbleitersubstrats gemäß einem Ausführungsbeispiel der vorliegenden Erfindung;
- Fig. 4b: einen Querschnitt des Halbleitersubstrats nach einem Schritt des strukturierten Aufbringens einer Maske auf den ersten Hauptoberflächenbereich des Halbleitersubstrats gemäß einem Ausführungsbeispiel der vorliegenden Erfindung;
- Fig. 4c: einen Querschnitt des Halbleitersubstrats nach dem Schritt des anisotropen Ätzens ausgehend von dem ersten Hauptoberflächenbereich in das Halbleitersubstrat gemäß einem Ausführungsbeispiel der vorliegenden Erfindung;
- Fig. 4d: einen Querschnitt des Halbleitersubstrats nach dem Schritt des Anordnens der Abdeckungsschicht auf den ersten Hauptoberflächenbereich des Halbleitersubstrats gemäß einem Ausführungsbeispiel der vorliegenden Erfindung;
- Fig. 4e: einen Querschnitt des Halbleitersubstrats nach einem Schritt des Anordnens der Abdeckungsschicht auf den ersten Hauptoberflächenbereich des Halbleitersubstrats, so dass die Abdeckungsschicht zumindest bereichsweise an der Ätzstruktur anliegt gemäß einem Ausführungsbeispiel der vorliegenden Erfindung;
- Fig. 4f: einen Querschnitt des Halbeitersubstrats nach dem Schritt des Entfernens des Materials des Halbleitersubstrats ausgehend von dem zweiten Hauptoberflächenbereich im Bereich der verformten Abdeckungsschicht gemäß einem Ausführungsbeispiel der vorliegenden Erfindung;
- Fig. 4g: einen Querschnitt eines Gehäuses zur Verkapselung eines Mikroscannerspiegels gemäß einem Ausführungsbeispiel der vorliegenden Erfindung;
- Fig. 5a: einen Querschnitt des Halbleitersubstrats nach dem Schritt des Bereitstellens des Halbleitersubstrats gemäß einem Ausführungsbeispiel der vorliegenden Erfindung;
- Fig. 5b: einen Querschnitt des Halbleitersubstrats nach einem Schritt des strukturierten Aufbringens einer Maske auf den ersten Hauptoberflächenbereich des Halbleitersubstrats gemäß einem Ausführungsbeispiel der vorliegenden Erfindung;
- Fig. 5c: einen Querschnitt des Halbleitersubstrats nach dem Schritt des anisotropen Ätzens ausgehend von dem ersten Hauptoberflächenbereich in das Halbleitersubstrat gemäß einem Ausführungsbeispiel der vorliegenden Erfindung;
- Fig. 5d: einen Querschnitt des Halbleitersubstrats nach dem Schritt des Anordnens der Abdeckungsschicht auf den ersten Hauptoberflächenbereich des Halbleitersubstrats gemäß einem Ausführungsbeispiel der vorliegenden Erfindung;
- Fig. 5e: einen Querschnitt des Halbleitersubstrats nach einem Schritt des Anordnens der Abdeckungsschicht auf den ersten Hauptoberflächenbereich des Halbleitersubstrats, so dass die Abdeckungsschicht zumindest bereichsweise an der Ätzstruktur anliegt gemäß einem Ausführungsbeispiel der vorliegenden Erfindung;
- Fig. 5f: einen Querschnitt des Halbeitersubstrats nach dem Schritt des Entfernens des Materials des Halbleitersubstrats ausgehend von dem zweiten Hauptoberflächenbereich im Bereich der verformten Abdeckungsschicht gemäß einem Ausführungsbeispiel der vorliegenden Erfindung;
- Fig. 5g: einen Querschnitt eines Gehäuses zur Verkapselung eines Mikroscannerspiegels gemäß einem Ausführungsbeispiel der vorliegenden Erfindung;
- Fig. 6a: einen Querschnitt des Halbleitersubstrats nach dem Schritt des Bereitstellens des Halbleitersubstrats gemäß einem Ausführungsbeispiel der vorliegenden Erfindung;
- Fig. 6b: einen Querschnitt des Halbleitersubstrats nach einem Schritt des strukturierten Aufbringens einer Maske auf den ersten Hauptoberflächenbereich des Halbleitersubstrats gemäß einem Ausführungsbeispiel der vorliegenden Erfindung;
- Fig. 6c: einen Querschnitt des Halbleitersubstrats nach dem Schritt des anisotropen Ätzens ausgehend von dem ersten Hauptoberflächenbereich in das Halbleitersubstrat gemäß einem Ausführungsbeispiel der vorliegenden Erfindung;
- Fig. 6d: einen Querschnitt des Halbleitersubstrats nach einem Schritt des Anordnens der Abdeckungsschicht auf den ersten Hauptoberflächenbereich des Halbleitersubstrats, so dass die Abdeckungsschicht zumindest bereichsweise an der Ätzstruktur anliegt gemäß einem Ausführungsbeispiel der vorliegenden Erfindung;
- Fig. 6e: einen Querschnitt des Halbeitersubstrats nach dem Schritt des Entfernens des Materials des Halbleitersubstrats ausgehend von dem zweiten Hauptoberflächenbereich im Bereich der verformten Abdeckungsschicht gemäß einem Ausführungsbeispiel der vorliegenden Erfindung;
- Fig. 6f: einen Querschnitt eines Gehäuses zur Verkapselung eines Mikroscannerspiegels gemäß einem Ausführungsbeispiel der vorliegenden Erfindung;
- Fig. 7: eine schematische Ansicht eines Halbleiteringots mit einer (100) Standardgitterorientierung;
- Fig. 8: eine schematische Ansicht einer Gitterstruktur des Halbleitersubstrats; und
- Fig. 9: ein Diagramm eines Querschnittprofils einer experimentell hergestellten Ätzstruktur 61.

In der nachfolgenden Beschreibung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

Ferner werden in der nachfolgenden Beschreibung zur Bezeichnung von Gitterebenen und/oder Gitterrichtungen einer Gitterstruktur (Kristallgitterstruktur) eines Halbleitersubstrats die Millerschen Indizes verwendet. Die Notation **(hkl)** bezeichnet dabei eine spezifische Gitterebene, während die Notation {**hkl**} alle symmetrisch äquivalenten Gitterebenen bezeichnet. Ferner bezeichnet die Notation **[uvw]** eine spezifische Gitterrichtung bzw. einen spezifischen Gittervektor, während die Notation **<uvw>** alle symetrisch äquivalenten Gittervektoren bezeichnet.

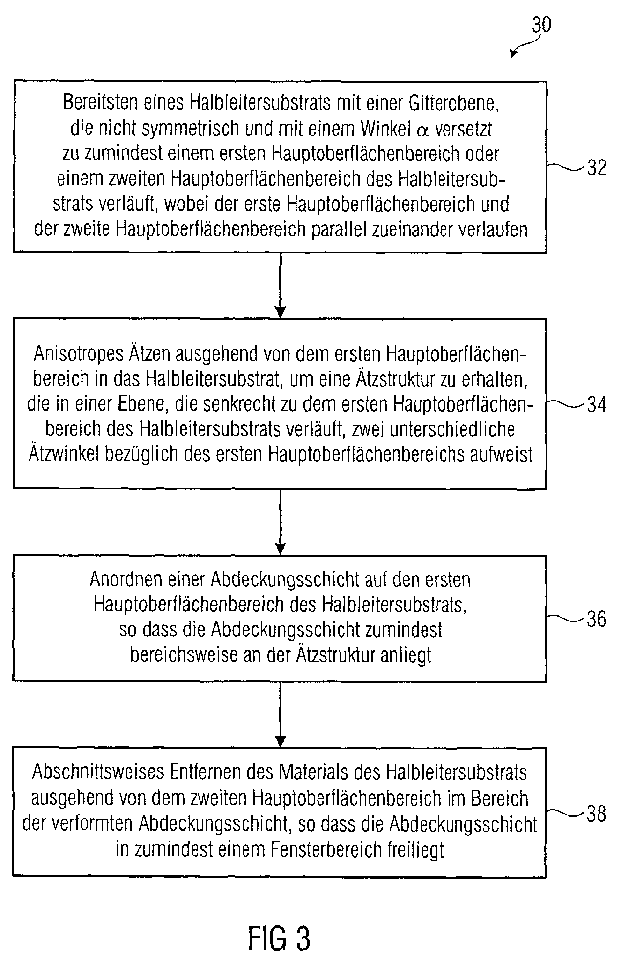

Fig. 3 zeigt ein Flussdiagramm eines Herstellungsverfahrens 30 gemäß einem Ausführungsbeispiel der vorliegenden Erfindung. In einem ersten Schritt 32 wird ein Halbleitersubstrat mit einer Gitterebene bereitgestellt, die nicht symmetrisch und mit einem Winkel α versetzt zu zumindest einem ersten Hauptoberflächenbereich oder einem zweiten Hauptoberflächenbereich des Halbleitersubstrats verläuft, wobei der erste Hauptoberflächenbereich und der zweite Hauptoberflächenbereich parallel zueinander verlaufen. In einem zweiten Schritt 34 wird ausgehend von dem ersten Hauptoberflächenbereich in das Halbleitersubstrat anisotrop geätzt, um eine Ätzstruktur zu erhalten, die in einer Ebene, die senkrecht zu dem ersten Hauptoberflächenbereich des Halbleitersubstrats verläuft, zwei unterschiedliche Ätzwinkel bezüglich des ersten Hauptoberflächenbereichs aufweist. In einem dritten Schritt 36 wird eine Abdeckungsschicht auf den ersten Hauptoberflächenbereich des Halbleitersubstrats angeordnet, so dass die Abdeckungsschicht zumindest bereichsweise an der Ätzstruktur anliegt. In einem vierten Schritt 38 wird das Material des Halbleitersubstrats ausgehend von dem zweiten Hauptoberflächenbereich im Bereich der verformten Abdeckungsschicht abschnittsweise entfernt, so dass die Abdeckungsschicht in zumindest einem Fensterbereich freiliegt.

Bei Ausführungsbeispielen wird ein Halbleitersubstrat bereitgestellt, dessen Gitterstruktur derart angeordnet ist, dass eine Gitterebene der Gitterstruktur, z.B. die (100) Gitterebene, nicht symmetrisch und mit einem Winkel α, z.B. einem Winkel zwischen 1° und 40°, versetzt zu zumindest einem ersten Hauptoberflächenbereich oder einem zweiten Hauptoberflächenbereich des Halbleitersubstrats angeordnet ist. Durch das Halbleitersubstrat mit der versetzt bzw. gekippt angeordneten Gitterebene kann mittels anisotropem Ätzen eine Ätzstruktur bereitgestellt werden, die in einer Ebene, die senkrecht zu dem ersten Hauptoberflächenbereich des Halbleitersubstrats verläuft, zwei unterschiedliche Ätzwinkel bezüglich des ersten Hauptoberflächenbereichs aufweist. Dadurch, dass eine Abdeckungsschicht auf den ersten Hauptoberflächenbereich des Halbleitersubstrats derart angeordnet wird, dass die Abdeckungsschicht zumindest bereichsweise an der Ätzstruktur anliegt, weist auch die Abdeckungsschicht zwei unterschiedliche Winkel (= Ätzwinkel) bezüglich des ersten Hauptoberflächenbereichs auf. Nach dem abschnittsweisen Entfernen des Materials des Halbleitersubstrats ausgehend von dem zweiten Hauptoberflächenbereich im Bereich der verformten Abdeckungsschicht, entsteht ein Fensterbereich in dem die Abdeckungsschicht nicht parallel, sondern versetzt bzw. gekippt zu dem ersten Hauptoberflächenbereich angeordnet ist.

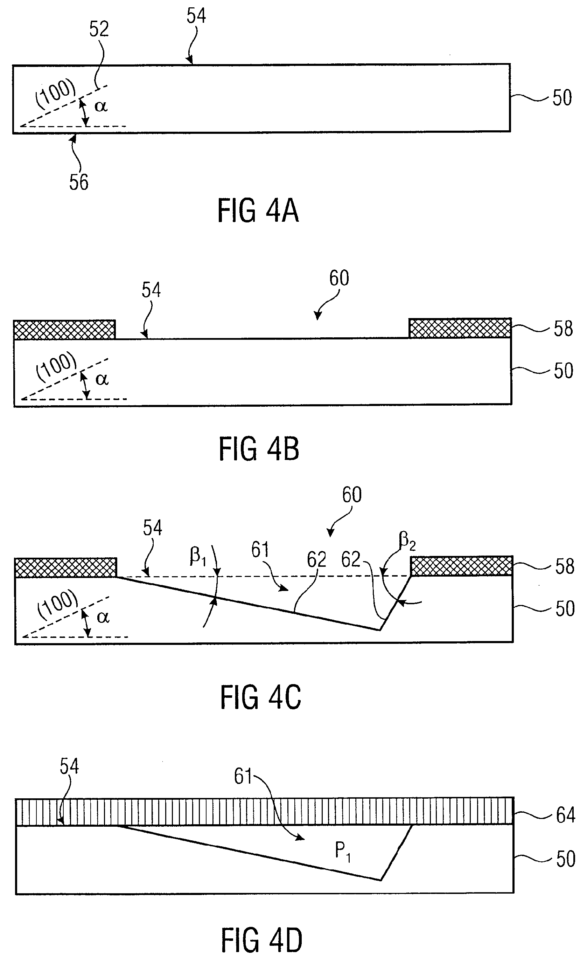

Im Folgenden werden Ausführungsbeispiele des erfindungsgemäßen Herstellungsverfahrens 30 anhand der Fig. 4a bis 4g näher erläutert. Die Fig. 4a bis 4g zeigen dabei Querschnitte des Halbleitersubstrats, der Abdeckungsschicht und/oder weiterer optionaler Merkmale nach den unterschiedlichen Schritten des erfindungsgemäßen Herstellungsverfahrens 30. Bei Ausführungsbeispielen bezieht sich der Ausdruck "Querschnitt" auf eine Schnittebene, die senkrecht zu dem ersten Hauptoberflächenbereich oder dem zweiten Hauptoberflächenbereich angeordnet ist.

Fig. 4a zeigt einen Querschnitt des Halbleitersubstrats 50 nach dem Schritt 32 des Bereitstellens des Halbleitersubstrats 50 gemäß einem Ausführungsbeispiel der vorliegenden Erfindung. Das Halbleitersubstrat 50 weist eine Gitterebene 52 auf, die nicht symmetrisch und mit einem Winkel α versetzt zu zumindest einem ersten Hauptoberflächenbereich 54 oder einem zweiten Hauptoberflächenbereich 56 des Halbleitersubstrats 50 verläuft, wobei der erste Hauptoberflächenbereich 54 und der zweiten Hauptoberflächenbereich 56 parallel zueinander verlaufen.

Bei Ausführungsbeispielen kann, wie in Fig. 4a gemäß einem Ausführungsbeispiel gezeigt ist, die Gitterebene des Halbleitersubstrats 50 die **(100)** Gitterebene sein. Mit anderen Worten, das in Fig. 4a gezeigte Halbleitersubstrat 50 weist eine anwendungsspezifische Orientierung auf. Dies bedeutet, dass das Halbleitersubstrat 50 keine **(100)** oder **(111)** Standardgitterorientierung aufweist, wie dies bei herkömmlichen mikroelektronischen oder mikroelektromechanischen Komponenten üblich ist, sondern dass das Halbleitersubstrat 50 relativ zu der **(100)** Gitterebene um einen Winkel α versetzt bzw. verkippt angeordnet ist. Die **(100)** oder **(111)** Gitterebene ist somit nicht, wie dies bei herkömmlichen mikroelektronischen oder mikroelektromechanischen Komponenten üblich ist, parallel zu dem ersten Hauptoberflächenbereich 54 oder zweiten Hauptoberflächenbereich 56 angeordnet, sondern nicht symmetrisch und mit einem Winkel α versetzt zu zumindest dem ersten Hauptoberflächenbereich 54 oder dem zweiten Hauptoberflächenbereich 56 angeordnet.

Der Winkel α kann in einem Bereich zwischen 1° und 40° (oder zwischen 10° und 30°, oder zwischen 18° und 22°, oder zwischen 15° und 25) liegen.

Bei Ausführungsbeispielen kann der Schritt 32 des Bereitstellens des Halbleitersubstrats 50 einen Schritt des Herausschneidens des Halbleitersubstrats 50 aus einem Halbleiteringot unter dem Winkel α umfassen, wobei der Halbleiteringot eine **(100)** Standardgitterorientierung aufweist.

Das Halbleitersubstrat 50 kann somit ein Halbleiterwafer 50 sein. Dabei kann der erste Hauptoberflächenbereich 54 eine "Oberseite" oder ein Bereich der "Oberseite" des Halbleiterwafers 50 sein, während der zweite Hauptoberflächenbereich 56 eine "Unterseite" oder ein Bereich der "Unterseite" des Halbleiterwafers 50 sein kann.

Bei Ausführungsbeispielen kann das Halbleitersubstrat 50 Silizium aufweisen. Es sei jedoch darauf hingewiesen, dass die vorliegende Erfindung nicht auf solche Ausführungsbeispiele beschränkt sei. Beispielsweise kann das Halbleitersubstrat 50 auch jedes andere beliebige Halbleitermaterial, wie z.B. Germanium, Galliumphosphid, Galliumarsenid, Indiumphosphid, Indiumarsenid, Galliumnitrid, Aluminiumgalliumarsenid, usw., aufweisen.

Fig. 4b zeigt einen Querschnitt des Halbleitersubstrats 50 nach einem Schritt des strukturierten Aufbringens einer Maske 58 auf den ersten Hauptoberflächenbereich 54 des Halbleitersubstrats 50 gemäß einem Ausführungsbeispiel der vorliegenden Erfindung. Dabei kann der erste Hauptoberflächenbereich 54 in einem Ätzbereich 60 freiliegen, wobei Kanten des Ätzbereichs 60 parallel zu **<110>** Richtungen der Gitterstruktur des Halbleitersubstrats 50 verlaufen können. Selbstverständlich kann der Ätzbereich auch eine andere geometrische Form aufweisen. Beispielsweise kann der Ätzbereich rund sein.

Bei Ausführungsbeispielen kann der Schritt des strukturierten Aufbringens der Maske 58 auf den ersten Hauptoberflächenbereich 54 des Halbleitersubstrats 50 einen Schritt des Aufdampfens oder Abscheidens der Maske 58 auf den ersten Hauptoberflächenbereich 54 des Halbleitersubstrats 50 und einen Schritt des Entfernens der Maske 58 in dem Ätzbereich 60 aufweisen. Das Aufbringen der Maske 58 kann mittels chemischer oder physikalischer Gasphasenabscheidung oder thermischer Prozesse erfolgen. Als Maske 58 kann z.B. ein dielektrisches Material zum Einsatz kommen, wobei zum Entfernen der Maske 58 in dem Ätzbereich 60 ein fotolithographisches Verfahren mit anschließender trockenchemischer oder nasschemischer Ätzung zum Einsatz kommen kann.

Der Ätzbereich 60 kann eine rechteckige oder quadratische Struktur aufweisen, wobei der Ätzbereich 60 derart auf dem ersten Hauptoberflächenbereich 54 angeordnet sein kann, dass Kanten der rechteckigen oder quadratischen Struktur des Ätzbereichs 60 parallel zu **<110>** Richtungen der Gitterstruktur des Halbleitersubstrats 50. Selbstverständlich kann der Ätzbereich auch eine andere geometrische Form aufweisen. Beispielsweise kann der Ätzbereich rund sein.

Beispielsweise kann der Schritt des Aufbringens der Maske 58 auf den ersten Hauptoberflächenbereich 54 des Halbleitersubstrats 50 einen Schritt des lithographischen Strukturierens des anwendungsspezifisch orientierten Halbleitersubstrats 50 mit der Struktur des zukünftigen Fensters umfassen. Die Struktur kann ein Array von Quadraten oder Rechtecken sein, wobei Kanten der Quadrate oder Rechtecke parallel zu **<110>** Richtungen verlaufen können. Wie bereits erwähnt, kann der Ätzbereich auch rund sein. Als Maske 58 kann beispielsweise eine LPCVD SiN Schicht verwendet werden (LPCVD = low pressure chemical vapour deposition; niederdruck chemische Gasphasenabscheidung) oder eine thermische oder CVD SiO2-Schicht.

Fig. 4c zeigt einen Querschnitt des Halbleitersubstrats 50 nach dem Schritt 34 des anisotropen Ätzens ausgehend von dem ersten Hauptoberflächenbereich 54 in das Halbleitersubstrat 50 zum Erhalten einer Ätzstruktur 61 gemäß einem Ausführungsbeispiel der vorliegenden Erfindung. Die Ätzstruktur 61 kann in einer Ebene, die senkrecht zu dem ersten Hauptoberflächenbereich 54 verläuft, zwei unterschiedliche Ätzwinkel β₁ und β₂ bezüglich des ersten Hauptoberflächenbereichs 54 aufweisen. Dabei kann, wie in Fig. 4c gemäß einem Ausführungsbeispiel gezeigt ist, das anisotrope Ätzen ausgehend von dem ersten Hauptoberflächenbereich 54 in das Halbleitersubstrat 50 in dem Ätzbereich 60 erfolgen.

Bei Ausführungsbeispielen können die bezüglich des ersten Hauptoberflächenbereichs 54 zwei unterschiedlichen Ätzwinkel β₁ und β₂ zwischen dem ersten Hauptoberflächenbereich 54 und jeweils einer **{111}** Gitterebenen 62 des Halbleitersubstrats liegen. Mit anderen Worten, ein erster Ätzwinkel β₁ der zwei unterschiedlichen Ätzwinkel β₁ und β₂ kann der Winkel zwischen dem ersten Hauptoberflächenbereich 54 des Halbleitersubstrats 50 und einer ersten **{111}** Gitterebene 62 des Halbleitersubstrats 50 sein, während der zweite Ätzwinkel β₂ der zwei unterschiedlichen Ätzwinkel β₁ und β₂ der Winkel zwischen dem ersten Hauptoberflächenbereich 54 des Halbleitersubstrats 50 und einer zweiten **{111}** Gitterebenen 62 des Halbleitersubstrats 50 sein kann, wobei die erste **{111}** Gitterebene und die zweite **{111}** Gitterebene unterschiedliche **{111}** Gitterebenen sind. Im Querschnitt kann die Ätzstruktur 61 somit durch zwei unterschiedliche **{111}** Gitterebenen 62 des Halbleitersubstrats 50 definiert sein. Mit anderen Worten, die Ätzstruktur 61 kann im Querschnitt durch zwei unterschiedliche **{111}** Gitterebenen 62 des Halbleitersubstrats 50 strukturell begrenzt sein.

Das anisotrope Ätzen kann den Schritt des Tetramethylammoniumhydroxid (TMAH) Ätzens, Kaliumhydroxid (KOH) Ätzens, oder Ethylendiaminpyrocatechol (EDP) Ätzens umfassen. Beispielsweise kann der strukturierte Wafer 50 in einer KOH oder TMAH Ätzlösung geätzt werden. Bedingt durch die geringe Äuflösungsrate (engl.: dissolution rate) der **{111}** Gitterebenen, entsteht die in Fig. 4c gezeigte Struktur.

Fig. 4d zeigt einen Querschnitt des Halbleitersubstrats 50 nach dem Schritt 36 des Anordnens der Abdeckungsschicht 64 auf den ersten Hauptoberflächenbereich 54 des Halbleitersubstrats 50 gemäß einem Ausführungsbeispiel der vorliegenden Erfindung.

Wie in Fig. 4d gemäß einem Ausführungsbeispiel gezeigt ist, kann der Schritt 36 des Anordnens der Abdeckungsschicht 64 auf den ersten Hauptoberflächenbereich 54 des Halbleitersubstrats 50 einen Schritt des Aufbringens der Abdeckungsschicht 64 auf den ersten Hauptoberflächenbereich 54 des Halbleitersubstrats 50 umfassen, so dass sich die Abdeckungsschicht 64 über die Ätzstruktur 61 erstreckt.

Die Abdeckungsschicht 64 kann zumindest in dem Fensterbereich optisch transparent sein. Optisch transparent bedeutet dabei, dass die Abdeckungsschicht 64 ausgebildet ist, um zumindest in dem Fensterbereich für elektromagnetische Wellen in einem vorgegebenen Wellenlängenbereich passierbar zu sein. Der vorgegebene Wellenlängenbereich kann z.B. im Bereich von 380 bis 780 nm (sichtbares Lichtspektrum), oder im Bereich von 780 nm bis 1 mm (Infrarotstrahlung), oder im Bereich von 10 bis 380 nm (Ultraviolettstrahlung) liegen.

Beispielsweise kann das erfindungsgemäße Herstellungsverfahren zum Hausen von Mikroscannerspiegeln genutzt werden. In diesem Fall kann der vorgegebene Wellenlängenbereich von dem Wellenlängenbereich eines auf den Mikroscannerspiegel einfallenden und reflektierten Lichtstrahls definiert werden, z.B. mit dem Ziel eine Dämpfung des einfallenden und reflektierten Lichtstrahls zu vermeiden bzw. gering zu halten, z.B. Dämpfung kleiner als 20%, 15%, 10%, 5%, 3%, 1 % oder 0,1%.

Bei Ausführungsbeispielen kann die Abdeckungsschicht 64 Glas aufweisen. Beispielsweise kann die Abdeckungsschicht 64 ein Glaswafer sein, der bei dem Schritt des Aufbringens der Abdeckungsschicht 64 auf den ersten Hauptoberflächenbereich 54 des Halbleitersubstrats 50, z.B. ein Halbleiterwafer 50, mit dem Halbleiterwafer 50 gebondet wird.

Der Schritt des Aufbringens der Abdeckungsschicht 64 auf den ersten Hauptoberflächenbereich 54 des Halbleitersubstrats 50 kann dabei unter einem ersten atmosphärischen Druck P₁ erfolgen, so dass zwischen der Abdeckungsschicht 64 und der Ätzstruktur der erste atmosphärische Druck P₁ herrscht. Die Abdeckungsschicht kann somit derart auf den ersten Hauptoberflächenbereich 54 des Halbleitersubstrats 50 aufgebracht werden, dass der erste atmosphärische Druck P₁ zwischen dem Ätzbereich 61 und der Abdeckungsschicht 64 eingeschlossen wird.

Der erste atmosphärische Druck P₁ kann beispielsweise Vakuum sein. Vakuum bezeichnet dabei den Zustand eines Gases in einem Volumen bei einem Druck, der deutlich geringer ist als der Atmosphärendruck bei Normalbedingungen, z.B. 1,01325 bar.

Beispielsweise kann der Strukturierte Wafer 50 mit einem Glaswafer 64, z.B. Pyrex® oder Borofloat®, im Vakuum gebondet werden. Als Bondverfahren kann anodisches Bonden zum Einsatz kommen, wobei selbstverständlich auch andere Bondverfahren verwendet werden können.

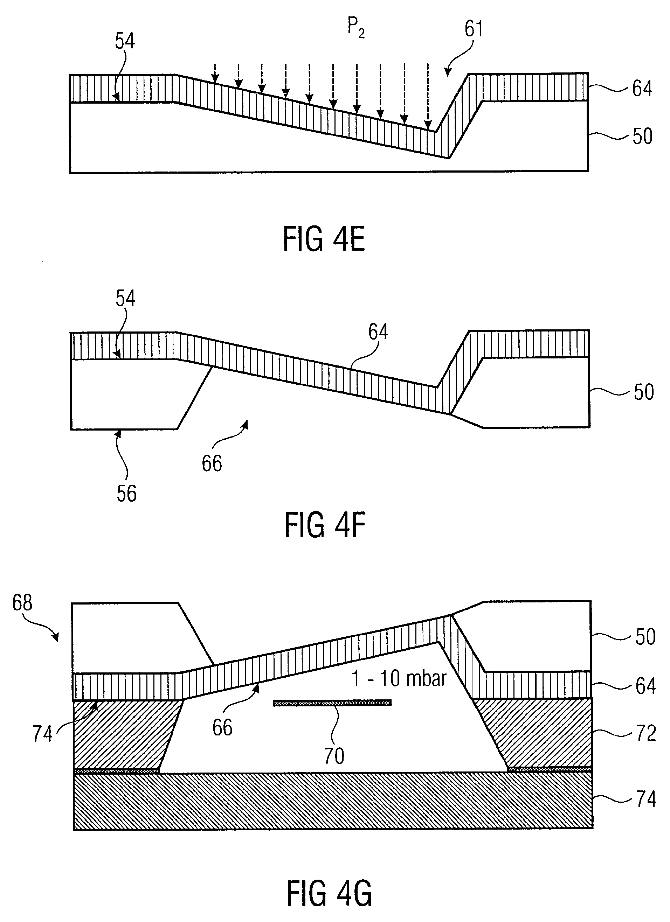

Fig. 4e zeigt einen Querschnitt des Halbleitersubstrats 50 nach einem 36 Schritt des Anordnens der Abdeckungsschicht auf den ersten Hauptoberflächenbereich 54 des Halbleitersubstrats 50, so dass die Abdeckungsschicht 64 zumindest bereichsweise an der Ätzstruktur 61 anliegt gemäß einem Ausführungsbeispiel der vorliegenden Erfindung.

Der Schritt 36 des Anordnens der Abdeckungsschicht 64 auf den ersten Hauptoberflächenbereich 54 des Halbleitersubstrats 50 kann einen Schritt des Verformens der in Fig. 4d gezeigten Abdeckungsschicht 64 im Bereich der Ätzstruktur 61 umfassen, so dass die Abdeckungsschicht 64 zumindest bereichsweise an der Ätzstruktur 61 anliegt.

Bei Ausführungsbeispielen kann das Verformen der Abdeckungsschicht 64 im Bereich der Ätzstruktur 61 unter einem zweiten atmosphärischem Duck P₂, der größer ist als der erste atmosphärische Druck P₁, und unter einer Temperatur, die höher ist, als ein Erweichungspunkt der Abdeckungsschicht 64, erfolgen, so dass sich die Abdeckungsschicht 64 durch eine Druckdifferenz zwischen dem ersten atmosphärischen Druck P₁ und dem zweiten atmosphärischen Druck P₂ im Bereich der Ätzstruktur 61 verformt, so dass die Abdeckungsschicht 64 zumindest bereichsweise an der Ätzstruktur 61 anliegt.

Beispielsweise kann der nach dem Bonden bereitgestellte Stapel (z.B. aus Siliziumwafer und Glaswafer) einem Temperaturschritt mit einer Temperatur, die höher ist als der Erweichungspunkt Tₛ des verwendeten Glases (z.B. für Pyrex® und Botofloat® Tₛ > 820 °C), unterzogen werden. Bedingt durch die Druckdifferenz zwischen der Vakuumkavität (P₁) und dem externen atmosphärischen Druck P2, wird das erweichte Glas in die Kavität geformt, die durch die **{111}** Gitterebenen des Siliziumsubstrats 50 geformt ist.

Fig. 4f zeigt einen Querschnitt des Halbeitersubstrats nach dem Schritt 38 des Entfernens des Materials des Halbleitersubstrats 50 ausgehend von dem zweiten Hauptoberflächenbereich 56 im Bereich der verformten Abdeckungsschicht 64 gemäß einem Ausführungsbeispiel der vorliegenden Erfindung. Wie in Fig. 4f gezeigt ist, wird das Material des Halbleitersubstrats 50 ausgehend von dem zweiten Hauptoberflächenbereich 56 im Bereich der verformten Abdeckungsschicht 64 derart entfernt, dass die Abdeckungsschicht 64 in zumindest einem Fensterbereich 66 freiliegt.

Mit anderen Worten, um das Fenster 64 für sichtbares Licht transparent zu machen wird das Silizium 50 ausgehend von der Rückseite des gekippten Fensters 64 geätzt.

Fig. 4g zeigt einen Querschnitt eines Gehäuses 68 zur Verkapselung eines Mikroscannerspiegels 70 gemäß einem Ausführungsbeispiel der vorliegenden Erfindung. Zur Herstellung des in Fig. 4g gezeigten Gehäuses 70 kann das erfindungsgemäße Herstellungsverfahren 30 ferner einen Schritt des Bereitstellens eines Vorrichtungshalbleitersubstrats 72 mit einem Mikroscannerspiegel 70, der in seiner Ruheposition parallel zu einer Oberfläche 74 des Vorrichtungshalbleitersubstrats 72 angeordnet ist, und einen Schritt des Bondens der Abdeckungsschicht 64 außerhalb des Bereichs der verformten Abdeckungsschicht 64 (Fensterbereich) mit der Oberfläche 74 des Vorrichtungshalbleitersubstrats 72, so dass der Fensterbereich 66 benachbart zu dem Mikroscannerspiegel 70 angeordnet ist, umfassen.

Bei Ausführungsbeispielen kann das Herstellungsverfahren 30 ferner die Schritte des Bereitstellens eines weiteren Halbleitersubstrats 74 und Bonden des weiteren Halbleitersubstrats 74 mit dem Vorrichtungshalbleitersubstrat 72, so dass das Halbleitersubstrat 50, das Vorrichtungshalbleitersubstrat 72 und das weitere Halbleitersubstrat 74 ein Gehäuse 68 zum Verkapseln, z.B. Vakuumverkapseln (mit einem Druck zwischen 1 und 10 mbar), des Mikroscannerspiegels 70 bilden, umfassen.

Mit anderen Worten, in Fig. 4g kann letztendlich das eingebettete gekippte Fenster 64 mit einem Vorrichtungswafer 72 gebondet werden, um die in Fig. 2 gezeigte Zielstruktur zu erhalten.

Ein Vorteil des erfindungsgemäßen Herstellungsverfahren 30 besteht darin, dass der in Fig. 4f gezeigte Wafer bzw. die in Fig. 4f gezeigte Struktur nicht vollständig aus Glas besteht, sondern eine Mehrzahl von gekippten Fenstern aufweist, die in Silizium eingebettet sind.

Dies hat den Vorteil, dass der Wafer einfach gehandhabt werden kann und dass das Risiko eines Bruchs während des Bondprozesses reduziert bzw. minimiert ist. Darüber hinaus ermöglicht der Siliziumrahmen zusätzlich Möglichkeiten zum Bonden der Struktur mit dem Vorrichtungswafer, wie z.B. Si-Si-Bonden, insbesondere dadurch, dass parallele Flächen zum Bonden und zur Krafteinleitung vorhanden sind.

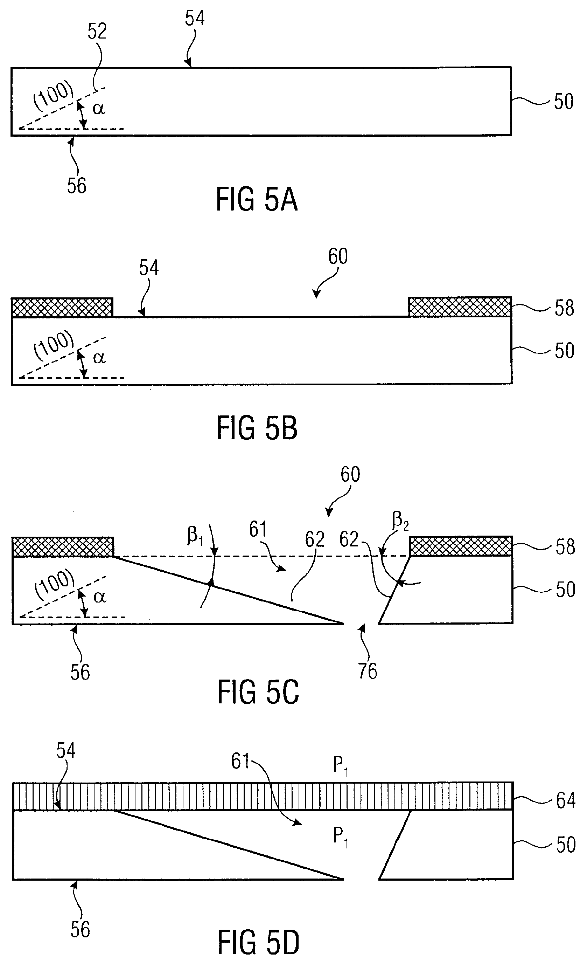

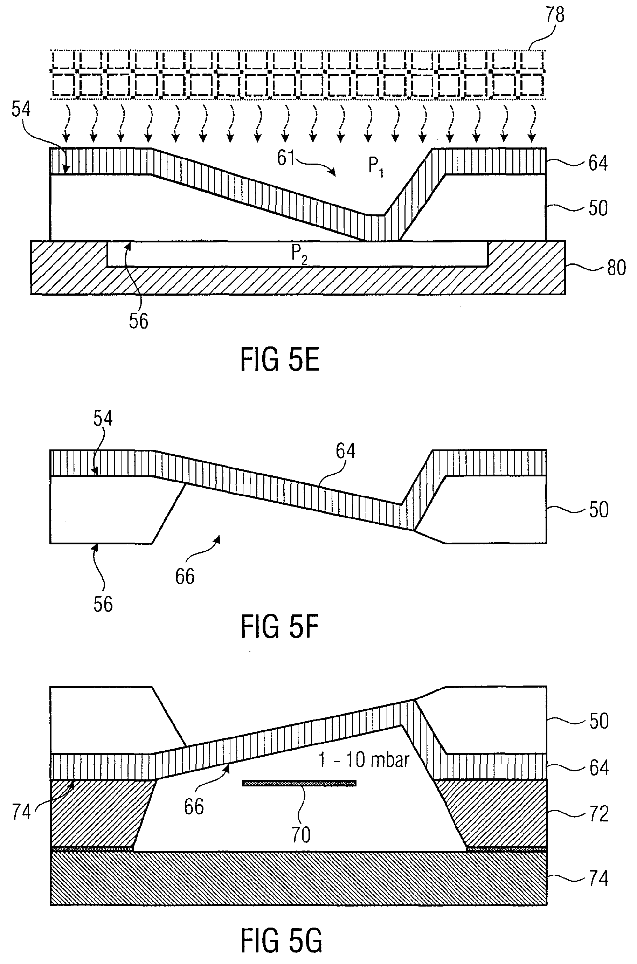

Im Folgenden werden weitere Ausführungsbeispiele des erfindungsgemäßen Herstellungsverfahrens 30 anhand der Fig. 5a bis 5g näher erläutert. Die Fig. 5a und 5b sowie 5f und 5g entsprechen dabei den Fig. 4a und 4b sowie 4f und 4g, so dass im Folgenden lediglich Unterschiede zwischen den Fig. 5c bis 5e zu den Fig. 4c bis 4e beschrieben werden.

Fig. 5c zeigt einen Querschnitt des Halbleitersubstrats 50 nach dem Schritt 34 des anisotropen Ätzens ausgehend von dem ersten Hauptoberflächenbereich in das Halbleitersubstrat 50 zum Erhalten einer Ätzstruktur 61 gemäß einem Ausführungsbeispiel der vorliegenden Erfindung. Die Ätzstruktur 61 kann in einer Ebene, die senkrecht zu dem ersten Hauptoberflächenbereich verläuft, zwei unterschiedliche Ätzwinkel β₁ und β₂ bezüglich des ersten Hauptoberflächenbereichs 54 aufweisen. Dabei kann, wie in Fig. 4c gemäß einem Ausführungsbeispiel gezeigt ist, das anisotrope Ätzen ausgehend von dem ersten Hauptoberflächenbereich 54 in das Halbleitersubstrat 50 in dem Ätzbereich 60 erfolgen.

Bei Ausführungsbeispielen kann das anisotrope Ätzen ausgehend von dem ersten Hauptoberflächenbereich 54 in das Halbleitersubstrat 50 bis zum zweiten Hauptoberflächenbereich 56 erfolgen, so dass sich die Ätzstruktur 61 von dem ersten Hauptoberflächenbereich 54 bis zum zweiten Hauptoberflächenbereich 56 erstreckt. Wie in Fig. 5c gezeigt ist, kann sich dabei ein Loch 76 in dem zweiten Hauptoberflächenbereich 56 bilden.

Mit anderen Worten, das in Fig. 4c gezeigte KOH-Ätzen kann ausgeweitet werden, so dass ein Loch 76 an der Rückseite 56 des Wafers 50 geöffnet wird.

Fig. 5d zeigt einen Querschnitt des Halbleitersubstrats 50 nach dem Schritt 36 des Anordnens der Abdeckungsschicht 64 auf den ersten Hauptoberflächenbereich 54 des Halbleitersubstrats 50 gemäß einem Ausführungsbeispiel der vorliegenden Erfindung.

Wie in Fig. 5d gemäß einem Ausführungsbeispiel gezeigt ist, kann der Schritt 36 des Anordnens der Abdeckungsschicht 64 auf den ersten Hauptoberflächenbereich 54 des Halbleitersubstrats 50 einen Schritt des Aufbringens der Abdeckungsschicht 64 auf den ersten Hauptoberflächenbereich 54 des Halbleitersubstrats 50, so dass sich die Abdeckungsschicht 64 über die Ätzstruktur 61 erstreckt, umfassen.

Im Gegensatz zu Fig. 4c, kann der Schritt des Aufbringens der Abdeckungsschicht 64 auf den ersten Hauptoberflächenbereich 54 des Halbleitersubstrats 50 unter einem (nahezu) beliebigen ersten atmosphärischen Druck P₁ erfolgen, z.B. einem Atmosphärendruck unter Normalbedingungen, wie z.B. einem Druck von 1,01325 bar. Mit anderen Worten, das Waferbonden in Fig. 5d muss nicht im Vakuum erfolgen.

Fig. 5e zeigt einen Querschnitt des Halbleitersubstrats 50 nach einem 36 Schritt des Anordnens der Abdeckungsschicht auf den ersten Hauptoberflächenbereich 54 des Halbleitersubstrats 50, so dass die Abdeckungsschicht zumindest bereichsweise an der Ätzstruktur 61 anliegt gemäß einem Ausführungsbeispiel der vorliegenden Erfindung.

Der Schritt 36 des Anordnens der Abdeckungsschicht auf den ersten Hauptoberflächenbereich 54 des Halbleitersubstrats 50 kann einen Schritt des Verformens der in Fig. 5d gezeigten Abdeckungsschicht 64 im Bereich der Ätzstruktur 61 umfassen, so dass die Abdeckungsschicht 64 zumindest bereichsweise an der Ätzstruktur 61 anliegt.

Bei Ausführungsbeispielen kann beim Verformen der Abdeckungsschicht 64 im Bereich der Ätzstruktur 61 benachbart zu der Abdeckungsschicht 64 ein erster atmosphärischer Druck P₁ und benachbart zu dem zweiten Hauptoberflächenbereich 56 ein zweiter atmosphärischer Druck P₂, der größer ist als der erste atmosphärischer Druck P₁, bereitgestellt werden, wobei das Verformen der Abdeckungsschicht 64 im Bereich der Ätzstruktur 61 unter einer Temperatur, die höher ist, als ein Erweichungspunkt der Abdeckungsschicht 64, erfolgt, so dass sich die Abdeckungsschicht 64 durch eine Druckdifferenz zwischen dem ersten atmosphärischer Druck P₁ und dem zweiten atmosphärischer Druck P₂ im Bereich der Ätzstruktur 61 verformt, so dass die Abdeckungsschicht 64 zumindest bereichsweise an der Ätzstruktur 61 anliegt.

Der zweite atmosphärische Druck P₂ kann beispielsweise Vakuum sein. Vakuum bezeichnet dabei den Zustand eines Gases in einem Volumen bei einem Druck, der deutlich geringer ist als der Atmosphärendruck bei Normalbedingungen.

Beispielsweise kann der Schritt des Verformens der Abdeckungsschicht 64 im Bereich der Ätzstruktur 61 in einer RTP-Kammer (RTP = Rapid Thermal Processing, dt. schnelle thermische Bearbeitung) mit einer RTP-Vorrichtung 78 und einer Vakuum-Spannvorrichtung (engl.: vacuum chuck) 80 erfolgen. Während des Annealing-Verfahrens bei einer Temperatur von mehr als 820 °C erzeugt die Spannvorrichtung 80 einen Unterdruck (zweiter atmosphärischer Druck P₂) bezogen auf den atmosphärischen Druck (ersten atmosphärischen Druck P₁ in der RTP-Kammer), so dass das gleiche Verformungsergebnis wie beim Vakuum-Bonden in Fig. 4 erzielt wird.

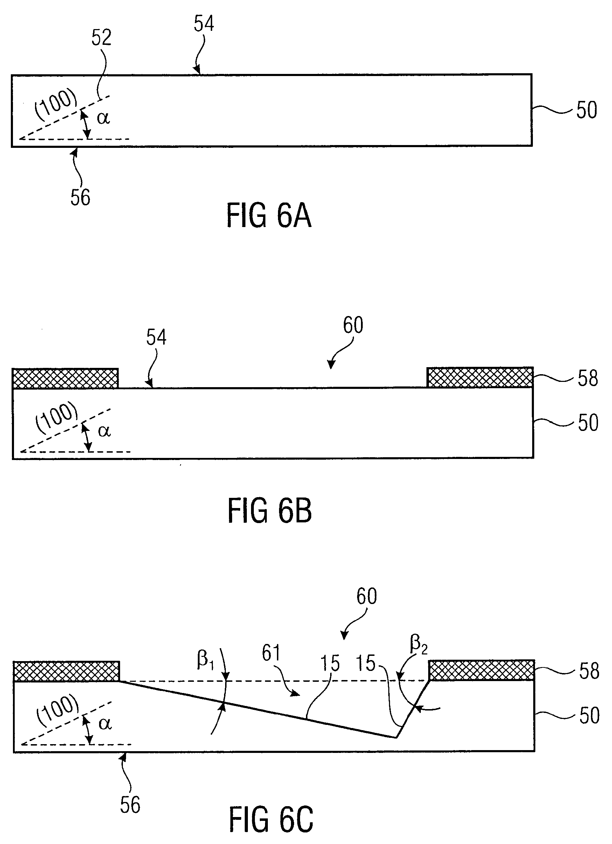

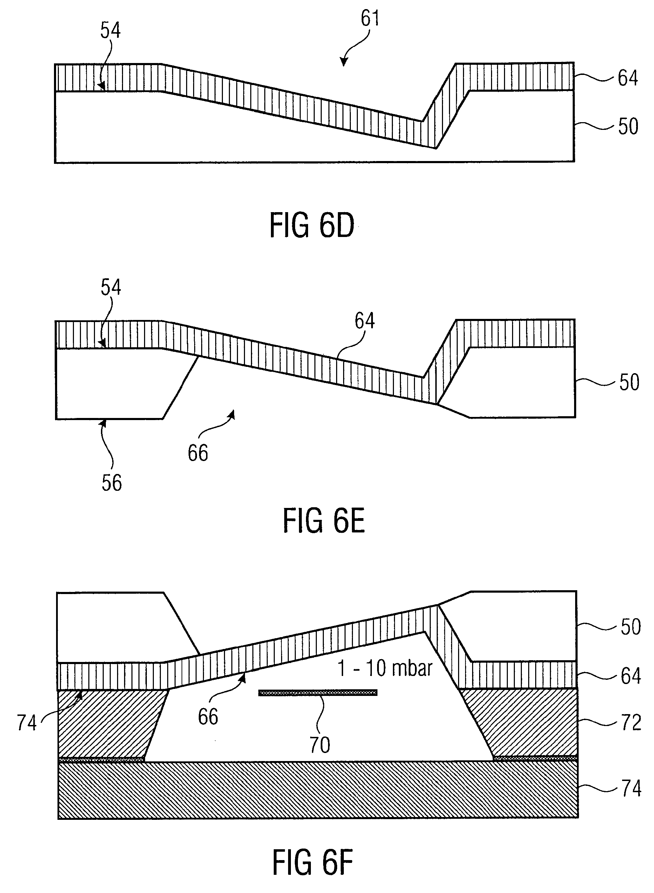

Im Folgenden werden weitere Ausführungsbeispiele des erfindungsgemäßen Herstellungsverfahrens 30 anhand der Fig. 6a bis 6f näher erläutert. Die Fig. 6a bis 6c sowie 6e und 6g entsprechen dabei den Fig. 4a bis 4c sowie 4f und 4g, so dass im Folgenden lediglich Unterschiede zwischen der Fig. 6d zu den Fig. 4d und 4e beschrieben werden.

Fig. 6d zeigt einen Querschnitt des Halbleitersubstrats 50 nach dem Schritt 36 des Anordnens der Abdeckungsschicht 64 auf den ersten Hauptoberflächenbereich 54 des Halbleitersubstrats 50 gemäß einem Ausführungsbeispiel der vorliegenden Erfindung.

Wie in Fig. 6d gemäß einem Ausführungsbeispiel gezeigt ist, kann der Schritt 36 des Anordnens der Abdeckungsschicht 64 auf den ersten Hauptoberflächenbereich 54 des Halbleitersubstrats 50 aufsputtern oder aufdampfen der Abdeckungsschicht 64 auf den ersten Hauptoberflächenbereich 54 des Halbleitersubstrats 50 umfassen.

Mit anderen Worten, anstelle des Schritts des Waferbondens kann ein Schritt des Abscheidens, z.B. aufsputtern oder aufdampfen, genutzt werden, um das Glas auf das Siliziumsubstrat mit der maßgeschneiderten Orientierung abzuscheiden.

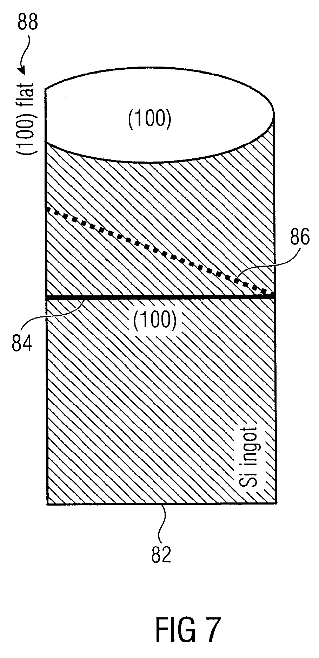

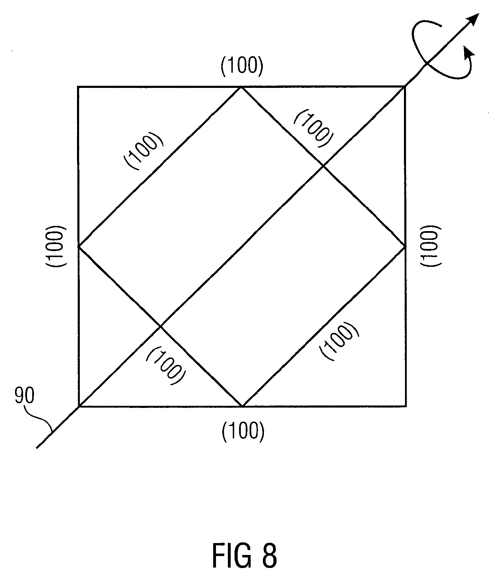

Wie bereits erwähnt, kann bei Ausführungsbeispielen der Schritt 32 des Bereitstellens des Halbleitersubstrats 50 einen Schritt des Herausschneidens des Halbleitersubstrats 50 aus einem Halbleiteringot unter dem Winkel α umfassen, wobei der Halbleiteringot eine (100) Standardgitterorientierung aufweist. Dies soll im Folgenden anhand der Fig. 7 und 8 näher erläutert werden.

Fig. 7 zeigt eine schematische Ansicht eines Halbleiteringots 82 mit einer **(100)** Standardgitterorientierung. In Fig. 7 wird die **(100)** Gitterebene des Halbleiteringots 82 durch eine erste Linie 84 angedeutet, die parallel zu der "Oberseite" des Halbleiteringots 82 verläuft. Ferner wird in Fig. 7 durch eine zweite (gestrichelte) Linie 86 eine Schnittebene angedeutet, die relativ zu der ersten Linie 84 um den Winkel α gekippt angeordnet ist. Darüber hinaus ist in Fig. 7 die Standartgitterorientierung des Halbleiteringots 82 durch eine "seitliche" Abflachung (engl. flat) 88 gekennzeichnet.

Durch das Herausschneiden des Halbleitersubstrats 50 aus dem Halbleiteringot 82 entlang der zweiten Linie 86 (Off-Achsen Schnittlinie) kann ein Halbleitersubstrat 50 mit einer Gitterebene bereitgestellt werden, die nicht symmetrisch und mit einem Winkel α versetzt zu zumindest einem ersten Hauptoberflächenbereich 54 oder einem zweiten Hauptoberflächenbereich 56 des Halbleitersubstrats 50 verläuft.

Mit anderen Worten, das anwendungsspezifisch orientierte Siliziumsubstrat 50 (Siliziumsubstrat mit einer individuell abgestimmten bzw. maßgeschneiderten Gitterorientierung) kann aus einem Halbleiteringot 82 herausgeschnitten werden. Im Gegensatz zu herkömmlichen Siliziumsubstraten, die eine **(100)** oder **(111)** Standartgitterorientierung aufweisen und für mikroelektronische bzw. mikroelektromechanische Vorrichtungen verwendet werden, weist das anwendungsspezifisch orientierte Halbleitersubstrat 50 eine Gitterorientierung auf, die relativ zu der **(100)** Gitterebene um den Winkel α versetzt angeordnet ist. Dies führt z.B. bei einem Siliziumhalbleitersubstrat 50 bei dem der Winkel zwischen der (100) und der (111) Gitterebene 54,7° beträgt, dazu, dass das Glasfenster 64 relativ zu der verkapselten Vorrichtung um einen Winkel β = α ± 54,7° angeordnet ist. Es sei jedoch darauf hingewiesen, dass die vorliegende Erfindung nicht auf solche Ausführungsbeispiele beschränkt sei. Wie bereits erwähnt kann das Halbleitersubstrat 50 auch jedes andere beliebige Halbleitermaterial, wie z.B. Germanium, Galliumphosphid, Galliumarsenid, Indiumphosphid, Indiumarsenid, Galliumnitrid, Aluminiumgalliumarsenid, usw., aufweisen.

Fig. 8 zeigt eine schematische Ansicht einer Gitterstruktur des Halbleitersubstrats. In Fig. 8 ist eine Symmetrieachse 90 angedeutet, die diagonal in der **(100)** Gitterebene liegt. Das anwendungsspezifisch orientierte Halbleitersubstrat 50 kann dabei durch eine Rotation der Gitterebene um die Symmetrieachse 90 um den Winkel α bereitgestellt werden. Mit anderen Worten, die Off-Achsen-Ebene kann durch Rotation um die Symmetrieachse 90 bereitgestellt werden.

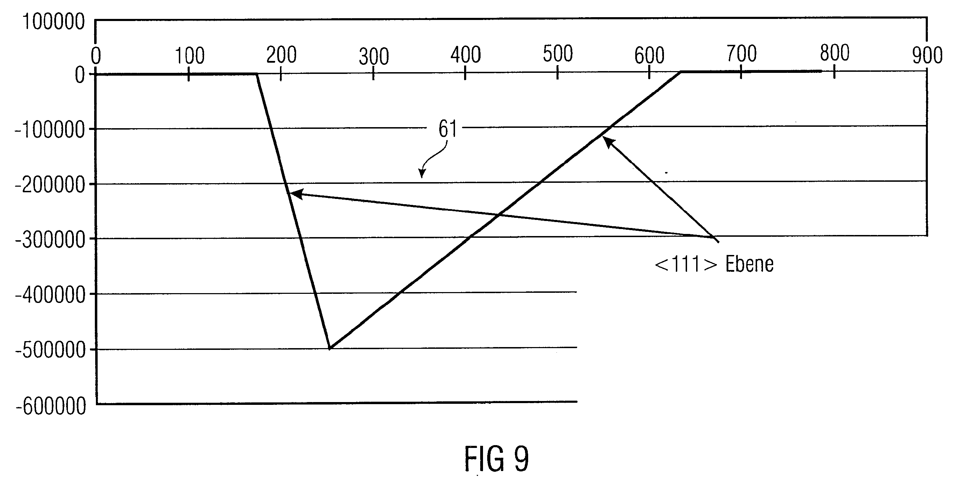

Im Folgenden werden Profilmessungen (Profilometer Messungen) experimentell hergestellter Ätzstrukturen 61 mit unterschiedlichen vertikalen und lateralen Ausdehnungen anhand der Fig. 9 gezeigt. Die vertikale Ausdehnung bezieht sich dabei auf eine Ausdehnung entlang einer Geraden, die senkrecht zu dem ersten Hauptoberflächenbereich 54 verläuft, während sich die laterale Ausdehnung auf eine Ausdehnung bezieht, die parallel zu dem ersten Hauptoberflächenbereich 54 verläuft. Bei der Herstellung der Ätzstrukturen 61 wurde ein Siliziumwafer 50 mit einer **(100)** Gitterebene verwendet, die um 20° versetzt zu dem ersten Hauptoberflächenbereich 54 angeordnet ist (ein um **(100)** + 20° missorientierter Si Wafer) und KOH zum anisotropen Ätzen.

Fig. 9 zeigt in einem Diagramm ein Profil einer experimentell hergestellten Ätzstruktur 61 im Querschnitt. Dabei beschreibt die Ordinate die vertikale Ausdehnung der Ätzstruktur 61 in Nanometern, und die Abszisse die horizontale Ausdehnung der Ätzstruktur in Anzahl der äquidistant gemessenen Punkte (~2 µm zwischen zwei benachbarten Punkten) entlang des ersten Hauptoberflächenbereichs 54. Die Ätzstruktur 61 weist dabei unterschiedliche **{111}** Ebenen auf.

Das hierin präsentierte Konzept zur Herstellung von gekippten Fenstern 64 zum Hausen von Mikrosystemchips auf Waferebene basiert auf dem Prinzip des Glasformens mittels speziell hergestellter Kavitäten in einem Siliziumsubstrat 50.

Das erfindungsgemäße Konzept unterscheidet sich von den bekannten bzw. herkömmlichen Konzepten durch die folgenden Punkte. Erstens, durch die Nutzung eines anwendungsspezifisch orientierten Siliziumsubstrats 50 als Vorlage zur Herstellung von gekippten Fenstern 64. Zweitens, dadurch, dass bei einem Ausführungsbeispiel kein Vakuum-Bonden zwischen dem Glaswafer 64 und dem Siliziumwafer 50 erforderlich ist, sondern dass der benötigte Überdruck zum Glasformen durch eine Vakuum-Spannvorrichtung bereitgestellt wird. Drittens, durch eine Kombination eines anwendungsspezifisch orientierten Siliziumsubstrats und Glasabscheidung, um letztendlich die gleiche Struktur zu erhalten, wie beim Formen eines Glaswafers 64 (Glasformen), der mit einem Siliziumwafer 50 gebondet ist. Viertens, dadurch, dass der endgültig strukturierte Wafer kein strukturierter Stand-Alone-Glaswafer ist, sondern ein Wafer mit Glasfenstern 64, die in einem Siliziumrahmen 50 eingebettet sind. Fünftens, dadurch, dass der endgültig strukturierte Wafer plan ist, so dass die Glasfenster 64 beim Bondprozess bzw. beim Hausen auf Waferebene (WLP) nicht durch das Aufbringen mechanischer Kräfte zerstört werden.

Weitere Ausführungsbeispiele der vorliegenden Erfindung beziehen sich auf ein Array von gekippten Fenstern, die durch die Verwendung von Glasformen mittels anwendungspezifisch orientierten Siliziumsubstraten auf Waferebene in einem Siliziumrahmen eingebettet sind. Anstelle von Vakuum-Bonden kann atmosphärisches Bonden verwendet werden, wobei der Temperaturschritt bezogen auf den atmosphärischen Druck bei Überdruck erfolgt. Anstelle von Glasformen kann Glasabscheiden auf anwendungsspezifisch orientierten Siliziumsubstraten zur Herstellung von gekippten Fenstern verwendet werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Herstellungsverfahren (30) zum Ausbilden einer verformten Abdeckungsschicht, mit folgenden Schritten:
Bereitstellen (32) eines Halbleitersubstrats (50) mit einer **(100)** Gitterebene, die nicht symmetrisch und mit einem Winkel α versetzt zu zumindest einem ersten Hauptoberflächenbereich (54) oder einem zweiten Hauptoberflächenbereich (56) des Halbleitersubstrats (50) verläuft, wobei der erste Hauptoberflächenbereich (54) und der zweite Hauptoberflächenbereich (56) parallel zueinander verlaufen;
abschnittsweises anisotropes Ätzen (34) ausgehend von dem ersten Hauptoberflächenbereich (54) in das Halbleitersubstrat (50), um eine Ätzstruktur (61) zu erhalten, die in einer Ebene, die senkrecht zu dem ersten Hauptoberflächenbereich (54) des Halbleitersubstrats (50) verläuft, zwei unterschiedliche Ätzwinkel (β₁, β₂) bezüglich des ersten Hauptoberflächenbereichs (54) aufweist;
Anordnen (36) einer Abdeckungsschicht (64) auf den ersten Hauptoberflächenbereich (54) des Halbleitersubstrats (50), so dass die Abdeckungsschicht (64) im Bereich der Ätzstruktur (61) so verformt ist, um zumindest bereichsweise an der Ätzstruktur (61) anzuliegen; und
abschnittweises Entfernen (38) des Materials des Halbleitersubstrats (50) ausgehend von dem zweiten Hauptoberflächenbereich (56) im Bereich der verformten Abdeckungsschicht (64), so dass in dem Halbleitersubstrat (50) ein Fensterbereich (66) entsteht, in dem die Abdeckungsschicht (64) nicht parallel zu dem ersten Hauptoberflächenbereich angeordnet ist und in dem die Abdeckungsschicht (64) freiliegt.

2. Herstellungsverfahren (30) gemäß Anspruch 1, wobei der Winkel α in einem Bereich zwischen 1° und 40° liegt

3. Herstellungsverfahren (30) gemäß Anspruch 1, wobei der Schritt des Bereitstellens (32) des Halbleitersubstrats (50) einen Schritt des Herausschneidens des Halbleitersubstrats (50) aus einem Halbleiteringot (82) unter dem Winkel α umfasst, wobei der Halbleiteringot (82) eine **(100)** Standardgitterorientierung aufweist.

4. Herstellungsverfahren (30) gemäß einem der Ansprüche 1 bis 3, ferner mit folgenden Schritten:
strukturiertes Aufbringen einer Maske (58) auf den ersten Hauptoberflächenbereich (54) des Halbleitersubstrats (50), wobei der erste Hauptoberflächenbereich (54) in einem Ätzbereich (60) freiliegt, und wobei Kanten des Ätzbereichs (60) parallel zu **<110>** Richtungen einer Gitterstruktur des Halbleitersubstrats (50) verlaufen;
wobei das anisotrope Ätzen (34) ausgehend von dem ersten Hauptoberflächenbereich (54) in das Halbleitersubstrat (50) in dem Ätzbereich (60) erfolgt.

5. Herstellungsverfahren (30) gemäß einem der Ansprüche 1 bis 4, wobei die bezüglich des ersten Hauptoberflächenbereichs (54) zwei unterschiedlichen Ätzwinkel (β₁, β₂) zwischen dem ersten Hauptoberflächenbereich (54) und jeweils einer **{111}** Gitterebene des Halbleitersubstrats (50) liegen.

6. Herstellungsverfahren (30) gemäß einem der Ansprüche 1 bis 5, wobei das Anordnen (36) der Abdeckungsschicht (64) auf den ersten Hauptoberflächenbereich (54) des Halbleitersubstrats (50) Aufsputtern, Abscheiden oder Aufdampfen der Abdeckungsschicht (64) auf den ersten Hauptoberflächenbereich (54) des Halbleitersubstrats (50) umfasst.

7. Herstellungsverfahren (30) gemäß einem der Ansprüche 1 bis 5, wobei das Anordnen (36) der Abdeckungsschicht (64) auf den ersten Hauptoberflächenbereich (54) des Halbleitersubstrats (50) folgende Schritte umfasst:
Aufbringen der Abdeckungsschicht (64) auf den ersten Hauptoberflächenbereich (54) des Halbleitersubstrats (50), so dass sich die Abdeckungsschicht (64) über die Ätzstruktur (61) erstreckt; und
Verformen der Abdeckungsschicht (64) im Bereich der Ätzstruktur (61), so dass die Abdeckungsschicht (64) zumindest bereichsweise an der Ätzstruktur (61) anliegt.

8. Herstellungsverfahren (30) gemäß Anspruch 7, wobei das Aufbringen der Abdeckungsschicht (64) unter einem ersten atmosphärischem Druck (P₁) erfolgt, so dass zwischen der Abdeckungsschicht (64) und der Ätzstruktur (61) der erste atmosphärische Druck (P₁) herrscht; und
wobei das Verformen der Abdeckungsschicht (64) im Bereich der Ätzstruktur (61) unter einem zweiten atmosphärischem Duck (P₂), der größer ist als der erste atmosphärische Druck (P₁), und unter einer Temperatur, die höher ist, als ein Erweichungspunkt der Abdeckungsschicht (64), erfolgt, so dass sich die Abdeckungsschicht (64) durch eine Druckdifferenz zwischen dem ersten atmosphärischen Druck (P₁) und dem zweiten atmosphärischen Druck (P₂) im Bereich der Ätzstruktur (61) verformt, so dass die Abdeckungsschicht (64) zumindest bereichsweise an der Ätzstruktur (61) anliegt.

9. Herstellungsverfahren (30) gemäß Anspruch 7, wobei das anisotrope Ätzen (34) ausgehend von dem ersten Hauptoberflächenbereich (54) in das Halbleitersubstrat (50) bis zu dem zweiten Hauptoberflächenbereich (56) erfolgt, so dass sich die Ätzstruktur (61) von dem ersten Hauptoberflächenbereich (54) bis zu dem zweiten Hauptoberflächenbereich (56) erstreckt;
wobei beim Verformen der Abdeckungsschicht (64) im Bereich der Ätzstruktur (61) benachbart zu der Abdeckungsschicht (64) ein erster atmosphärischer Druck (P₁) und benachbart zu dem zweiten Hauptoberflächenbereich (56) ein zweiter atmosphärischer Druck (P₂), der größer ist als der erste atmosphärischer Druck (P₁), bereitgestellt wird, und wobei das Verformen der Abdeckungsschicht (64) im Bereich der Ätzstruktur (61) unter einer Temperatur, die höher ist, als ein Erweichungspunkt der Abdeckungsschicht (64), erfolgt, so dass sich die Abdeckungsschicht (64) durch eine Druckdifferenz zwischen dem ersten atmosphärischer Druck (P₁) und dem zweiten atmosphärischer Druck (P₂) im Bereich der Ätzstruktur (61) verformt, so dass die Abdeckungsschicht (64) zumindest bereichsweise an der Ätzstruktur (61) anliegt.

10. Herstellungsverfahren (30) gemäß einem der Ansprüche 1 bis 9, wobei das Anordnen (36) der Abdeckungsschicht Bonden umfasst.

11. Herstellungsverfahren (30) gemäß einem der Ansprüche 1 bis 10, wobei die Abdeckungsschicht (64) zumindest in dem Fensterbereich (66) optisch transparent ist.

12. Herstellungsverfahren (30) gemäß einem der Ansprüche 1 bis 11, wobei die Abdeckungsschicht (64) Glas aufweist.

13. Herstellungsverfahren (30) gemäß einem der Ansprüche 1 bis 12, ferner mit folgenden Schritten:
Bereitstellen eines Vorrichtungshalbleitersubstrats (72) mit einem Mikroscannerspiegel (70) der in seiner Ruheposition parallel zu einem Oberflächenbereich (74) des Vorrichtungshalbleitersubstrats (72) angeordnet ist;
Bonden der Abdeckungsschicht (64) außerhalb des Bereichs der verformten Abdeckungsschicht (64) auf den Oberflächenbereich (74) des Vorrichtungshalbleitersubstrats (72), so dass der Fensterbereich (66) benachbart zu dem Mikroscannerspiegel (70) angeordnet ist.

## Claims

1. Production method (30) for forming a deformed cover layer, comprising the following steps:
providing (32) a semiconductor substrate (50) comprising a **(100)** lattice plane that extends in a non-symmetrical manner and such that it is offset at an angle α from at least a first main surface region (54) or a second main surface region (56) of the semiconductor substrate (50), the first main surface region (54) and the second main surface region (56) extending parallel to each other;
starting from the first main surface region (54), section-by-section anisotropic etching (34) into the semiconductor substrate (50) so as to obtain an etching structure (61) which comprises, in a plane extending perpendicularly to the first main surface region (54) of the semiconductor substrate (50), two different etching angles (β₁, β₂) relative to the first main surface region (54);
arranging (36) a cover layer (64) on the first main surface region (54) of the semiconductor substrate (50), so that the cover layer (64) is deformed in the area of the etching structure (61) to lie against the etching structure (61) in at least some sections; and
removing (38), section-by-section, the material of the semiconductor substrate (50) starting from the second main surface region (56) in the area of the deformed cover layer (64), so that in the semiconductor substrate (50) a window region (66) is formed wherein the cover layer (64) is arranged in a manner that is non-parallel to the first main surface region and wherein the cover layer (64) is exposed.

2. Production method (30) as claimed in claim 1, wherein the angle α ranges from 1° to 40°.

3. Production method (30) as claimed in claim 1, wherein the step of providing (32) the semiconductor substrate (50) includes a step of cutting out the semiconductor substrate (50) from a semiconductor ingot (82) at the angle α, said semiconductor ingot (82) comprising a (100) standard lattice orientation.

4. Production method (30) as claimed in any of claims 1 to 3, further comprising:
structured application of a mask (58) onto the first main surface region (54) of the semiconductor substrate (50), said first main surface region (54) being exposed in an etching region (60), and edges of the etching region (60) extending parallel to **<110>** directions of a lattice structure of the semiconductor substrate (50);
said anisotropic etching (34) being performed starting from the first main surface region (54) into the semiconductor substrate (50) within the etching region (60).

5. Production method (30) as claimed in any of claims 1 to 4, wherein the two etching angles (β₁, β₂) that differ relative to the first main surface region (54) are located between the first main surface region (54) and one **{111}** lattice plane of the semiconductor substrate (50), respectively.

6. Production method (30) as claimed in any of claims 1 to 5, wherein arranging (36) the cover layer (64) on the first main surface region (54) of the semiconductor substrate (50) includes sputter deposition, deposition or vapor deposition of the cover layer (64) onto the first main surface region (54) of the semiconductor substrate (50).

7. Production method (30) as claimed in any of claims 1 to 5, wherein arranging (36) the cover layer (64) on the first main surface region (54) of the semiconductor substrate (50) comprises the following steps:
applying the cover layer (64) onto the first main surface region (54) of the semiconductor substrate (50), so that the cover layer (64) extends across the etching structure (61); and
deforming the cover layer (64) in the area of the etching structure (61), so that cover layer (64) lies against the etching structure (61) in at least some sections.

8. Production method (30) as claimed in claim 7, wherein said application of the cover layer (64) is performed under a first atmospheric pressure (P₁), so that the first atmospheric pressure (P₁) exists between the cover layer (64) and the etching structure (61); and
wherein said deformation of the cover layer (64) in the area of the etching structure (61) may be performed under a second atmospheric pressure (P₂) larger than the first atmospheric pressure (P₁), and at a temperature higher than a softening point of the cover layer (64), so that the cover layer (64) will deform in the area of the etching structure (61) due to a pressure difference between the first atmospheric pressure (P₁) and the second atmospheric pressure (P₂), so that the cover layer (64) lies against the etching structure (61) in at least some sections.

9. Production method (30) as claimed in claim 7, wherein said anisotropic etching (34) may be performed starting from the first main surface region (54) into the semiconductor substrate (50) to the second main surface region (56), so that the etching structure (61) will extend from the first main surface region (54) to the second main surface region (56),
wherein in the deformation of the cover layer (64) in the area of the etching structure (61), a first atmospheric pressure (P₁) is provided adjacently to the cover layer (64), and a second atmospheric pressure (P₂) larger than the first atmospheric pressure (P₁) is provided adjacently to the second main surface region (56), said deformation of the cover layer (64) in the area of the etching structure (61) being performed at a temperature higher than a softening point of the cover layer (64), so that the cover layer (64) will deform in the area of the etching structure (61) due to a pressure difference between the first atmospheric pressure (P₁) and the second atmospheric pressure (P₂), so that the cover layer (64) lies against the etching structure (61) in at least some sections.

10. Production method (30) as claimed in any of claims 1 to 9, wherein said arranging (36) of the cover layer includes bonding.

11. Production method (30) as claimed in any of claims 1 to 10, wherein the cover layer (64) is optically transparent at least in the window region (66).

12. Production method (30) as claimed in any of claims 1 to 11, wherein the cover layer (64) comprises glass.

13. Production method (30) as claimed in any of claims 1 to 12, further comprising:
providing a device semiconductor substrate (72) comprising a microscanner mirror (70), which in its idle position is arranged in parallel with a surface region (74) of the device semiconductor substrate (72);
bonding the cover layer (64) outside the area of the deformed cover layer (64) onto the surface region (74) of the device semiconductor substrate (72), so that the window region (66) is arranged adjacently to the microscanner mirror (70).

## Revendications

1. Procédé de fabrication (30) pour former une couche de recouvrement déformée, aux étapes suivantes consistant à:
préparer (32) un substrat semi-conducteur (50) avec un plan réticulaire (100) qui s'étend de manière non symétrique et décalé selon un angle α par rapport à au moins une première zone de surface principale (54) ou une deuxième zone de surface principale (56) du substrat semi-conducteur (50), la première zone de surface principale (54) et la deuxième zone de surface principale (56) étant parallèles l'une à l'autre;
par segment, graver de manière anisotrope (34), en partant de la première zone de surface principale (54), le substrat semi-conducteur (50), pour obtenir une structure gravée (61) qui présente, dans un plan qui s'étend de manière perpendiculaire à la première zone de surface principale (54) du substrat semi-conducteur (50), deux angles de gravure différents (β₁ β₂) par rapport à la première zone de surface principale (54);
disposer (36) une couche de recouvrement (64) sur la première zone de surface principale (54) du substrat semi-conducteur (50), de sorte que la couche de recouvrement (64) soit déformée à l'endroit de la structure gravée (61) de sorte qu'elle s'appuie au moins par zones sur la structure gravée (61); et
par segment, enlever (38) le matériau du substrat semi-conducteur (50), en partant de la deuxième zone de surface principale (56) à l'endroit de la couche de recouvrement déformée (64), de sorte que soit créée dans le substrat semi-conducteur (50) une zone de fenêtre (66) dans laquelle la couche de recouvrement (64) n'est pas disposée de manière parallèle à la première zone de surface principale et dans laquelle la couche de recouvrement (64) est exposée.

2. Procédé de fabrication (30) selon la revendication 1, dans lequel l'angle α se situe dans une plage comprise entre 1° et 40°.

3. Procédé de fabrication (30) selon la revendication 1, dans lequel l'étape consistant à préparer (32) le substrat semi-conducteur (50) comporte une étape consistant à découper le substrat semi-conducteur (50) d'un lingot semi-conducteur (82) selon l'angle α, le lingot semi-conducteur (82) présentant une orientation de réseau standard (100).

4. Procédé de fabrication (30) selon l'une des revendications 1 à 3, par ailleurs aux étapes suivantes consistant à:
appliquer de manière structurée un masque (58) sur la première zone de surface principale (54) du substrat semi-conducteur (50), la première zone de surface principale (54) étant exposée dans une zone de gravure (60), et les bords de la zone de gravure (60) s'étendant de manière parallèle aux <110> directions d'une structure réticulaire du substrat semi-conducteur (50);
dans lequel la gravure anisotrope (34) en partant de la première zone de surface principale (54) dans le substrat semi-conducteur (50) a lieu dans la zone de gravure (60).

5. Procédé de fabrication (30) selon l'une quelconque des revendications 1 à 4, dans lequel les deux angles de gravure différents (β₁, β₂) par rapport à la première zone de surface principale (54) se situent entre la première zone de surface principale (54) et chaque fois un plan réticulaire {111} du substrat semi-conducteur (50).

6. Procédé de fabrication (30) selon l'une des revendications 1 à 5, dans lequel la disposition (36) de la couche de recouvrement (64) sur la première zone de surface principale (54) du substrat semi-conducteur (50) comporte le dépôt par pulvérisation, le dépôt ou le dépôt en phase vapeur de la couche de recouvrement (64) sur la première zone de surface principale (54) du substrat semi-conducteur (50).

7. Procédé de fabrication (30) selon l'une des revendications 1 à 5, dans lequel la disposition (36) de la couche de recouvrement (64) sur la première zone de surface principale (54) du substrat semi-conducteur (50) comporte les étapes suivantes consistant à:
appliquer la couche de recouvrement (64) sur la première zone de surface principale (54) du substrat semi-conducteur (50) de sorte que la couche de recouvrement (64) s'étende sur la structure gravée (61); et
déformer la couche de recouvrement (64) à l'endroit de la structure gravée (61), de sorte que la couche de recouvrement (64) s'appuie au moins par zones sur la structure gravée (61).

8. Procédé de fabrication (30) selon la revendication 7, dans lequel l'application de la couche de recouvrement (64) a lieu sous une première pression atmosphérique (P₁), de sorte qu'entre la couche de recouvrement (64) et la structure gravée (61) règne la première pression atmosphérique (P₁); et
dans lequel la déformation de la couche de recouvrement (64) à l'endroit de la structure gravée (61) a lieu sous une deuxième pression atmosphérique (P₂) qui est supérieure à la première pression atmosphérique (P₁), et à une température qui est supérieure à un point de ramollissement de la couche de recouvrement (64), de sorte que la couche de recouvrement (64) se déforme par une différence de pression entre la première pression atmosphérique (P₁) et la deuxième pression atmosphérique (P₂) à l'endroit de la structure gravée (61), de sorte que la couche de recouvrement (64) s'appuie au moins par zones sur la structure gravée (61).

9. Procédé de fabrication (30) selon la revendication 7, dans lequel la gravure anisotrope (34) en partant de la première zone de surface principale (54) dans le substrat semi-conducteur (50) a lieu jusqu'à la deuxième zone de surface principale (56), de sorte que la structure gravée (61) s'étende de la première zone de surface principale (54) jusqu'à la deuxième zone de surface principale (56);
dans lequel est mise à disposition, lors de la déformation de la couche de recouvrement (64) à l'endroit de la structure gravée (61) adjacent à la couche de recouvrement (64), une première pression atmosphérique (P₁) et, adjacent à la deuxième zone de surface principale (56), une deuxième pression atmosphérique (P₂) qui est supérieure à la première pression atmosphérique (P₁), et dans lequel la déformation de la couche de recouvrement (64) à l'endroit de la structure gravée (61) a lieu à une température qui est supérieure à un point de ramollissement de la couche de recouvrement (64), de sorte que la couche de recouvrement (64) se déforme par une différence de pression entre la première pression atmosphérique (P₁) et la deuxième pression atmosphérique (P₂) à l'endroit de la structure gravée (61), de sorte que la couche de recouvrement (64) s'appuie au moins par zones sur la structure gravée (61).

10. Procédé de fabrication (30) selon l'une des revendications 1 à 9, dans lequel la disposition (36) de la couche de recouvrement comprend l'assemblage.

11. Procédé de fabrication (30) selon l'une des revendications 1 à 10, dans lequel la couche de recouvrement (64) est optiquement transparente au moins dans la zone de fenêtre (66).

12. Procédé de fabrication (30) selon l'une des revendications 1 à 11, dans lequel la couche de recouvrement (64) présente du verre.

13. Procédé de fabrication (30) selon l'une des revendications 1 à 12, par ailleurs aux étapes suivantes consistant à:
préparer un substrat semi-conducteur de dispositif (72) avec un micro-miroir de balayage (70) qui est disposé, dans sa position de repos, de manière parallèle à une zone de surface (74) du substrat semi-conducteur de dispositif (72);
assembler la couche de recouvrement (64) en-dehors de la zone de la couche de recouvrement déformée (64) sur la zone de surface (74) du substrat semi-conducteur de dispositif (72), de sorte que la zone de fenêtre (66) soit disposé adjacente au micro-miroir de balayage (70).
